# EUROPÄISCHE PATENTANMELDUNG

(11) **EP 2 124 341 A1**
(43) Veröffentlichungstag der Anmeldung: **25.11.2009**
(21) Anmeldenummer: 09001730.2
(22) Anmeldetag: 07.02.2009
(51) Int. Cl.: H03K 17/78

(54) **Elektrische Schaltung zur Ansteuerung eines Leistungshalbleiterschaltelements**

(30) Priorität: 23.05.2008 DE 102008024787
(71) Anmelder: Converteam Technology Ltd, Rugby Warwickshire CV21 1BU (GB)
(72) Erfinder: Oesterle, Robert, 12555 Berlin (DE)
(74) Vertreter: Schäfer, Wolfgang

(57) **Zusammenfassung**

Es wird eine elektrische Schaltung zur Ansteuerung eines Leistungshalbleiterschaltelements beschrieben, die eine Steuereinheit (11) zur Erzeugung eines Steuersignals, ein Treibermodul (14) zur Ansteuerung des Leistungshalbleiterschaltelements in Abhängigkeit von dem Steuersignal, und eine Einrichtung zur potentialfreien Übertragung des Steuersignals von der Steuereinheit (11) zu dem Treibermodul (14) aufweist. Die Einrichtung zur potentialfreien Übertragung weist einen Sender (18) und einen Empfänger (19) auf, zwischen denen keine direkte körperliche Verbindung vorhanden ist.

## Beschreibung

Die Erfindung betrifft eine elektrische Schaltung zur Ansteuerung eines Leistungshalbleiterschaltelements.

Zur Ansteuerung von Leistungshalbleiterschaltelementen ist es bekannt, aus funktionalen Gründen oder Sicherheitsgründen eine potentialfreie Übertragung von Steuersignalen vorzusehen. Dies kann mit Hilfe von Transformatoren oder Optokopplern realisiert werden, wie dies beispielhaft in der DE 44 21 837 A1 beschrieben ist. Ein Nachteil der dort gezeigten elektrischen Schaltung besteht unter anderem in deren hohem Bauteileaufwand.

Aufgabe der Erfindung ist es, eine elektrische Schaltung zu schaffen, die eine einfachere Ansteuerung von Leistungshalbleiterschaltelementen ermöglicht.

Diese Aufgabe wird durch eine elektrische Schaltung nach dem Anspruch 1 gelöst.

Die elektrische Schaltung weist eine Steuereinheit zur Erzeugung eines Steuersignals auf. Ein Treibermodul ist dazu vorgesehen, ein zugehöriges Leistungshalbleiterschaltelement in Abhängigkeit von dem Steuersignal anzusteuern. Die Schaltung weist weiterhin einen Sender und einen Empfänger auf, zwischen denen keine direkte körperliche Verbindung vorhanden ist. Über diesen Sender und Empfänger wird das Steuersignal übertragen.

Da zwischen dem Sender und dem Empfänger keine direkte körperliche Verbindung vorhanden ist, können der Sender und der Empfänger mit unterschiedlichen Potentialen betrieben werden. Die Übertragungsstrecke zwischen dem Sender und dem Empfänger stellt damit eine potentialfreie Übertragungsstrecke dar.

Weiterhin wird durch die körperliche Trennung des Senders und des Empfängers erreicht, dass auch keine Kriechströme oder kapazitive Ausgleichsströme oder dergleichen zwischen dem Sender und dem Empfänger entstehen können.

Gleichzeitig eröffnet die Verwendung des Senders und des Empfängers die Möglichkeit, die Steuersignale mit Hilfe von Lichtsignalen oder per Funk zu realisieren. Dies stellt eine besonders einfache und kostengünstige Realisierung der erfindungsgemäßen Schaltung dar.

Ein weiterer Vorteil der Verwendung des Senders und des Empfängers besteht darin, dass die Montage der gesamten Schaltung wesentlich vereinfacht wird und insbesondere auch die Möglichkeit von Montagefehlern verringert wird.

Sofern der Sender und der Empfänger auf einer gemeinsamen Leiterplatte oder dergleichen aufgebracht sind, ist erfindungsgemäß vorgesehen, dass sie sich körperlich nicht berühren. Besonders vorteilhaft ist es dabei, wenn der Sender und der Empfänger mit Hilfe isolierender Materialien in einem gewissen Abstand auf der Leiterplatte montiert sind. Damit wird erreicht, dass Kriechströme oder kapazitive Ausgleichsströme oder dergleichen über irgendwelche Verbindungsteile zwischen dem Sender und dem Empfänger minimiert werden.

Bei einer Ausgestaltung der Erfindung erfolgt die Übertragung der Steuersignale über eine eher kurze Strecke und vorzugsweise durch die Luft. Damit wird der Aufbau der Schaltung und der hierzu erforderliche Aufwand weiter reduziert.

Bei einer besonders vorteilhaften Weiterbildung der Erfindung erfolgt die Übertragung der Lichtsignale nach einem seriellen Protokoll, insbesondere nach dem IrDA-Protokoll. Damit kommt eine Übertragungstechnik zur Anwendung, die einerseits eine zuverlässige und genaue Übertragung der Steuersignale gewährleistet, und die andererseits nur mit einem geringen Realisierungsaufwand verbunden ist.

Die Erfindung stellt insgesamt eine elektrische Schaltung für den Bereich der Leistungselektronik zur Verfügung, die mit geringem Aufwand eine sichere und potentialfreie Übertragung von Steuersignalen ermöglicht.

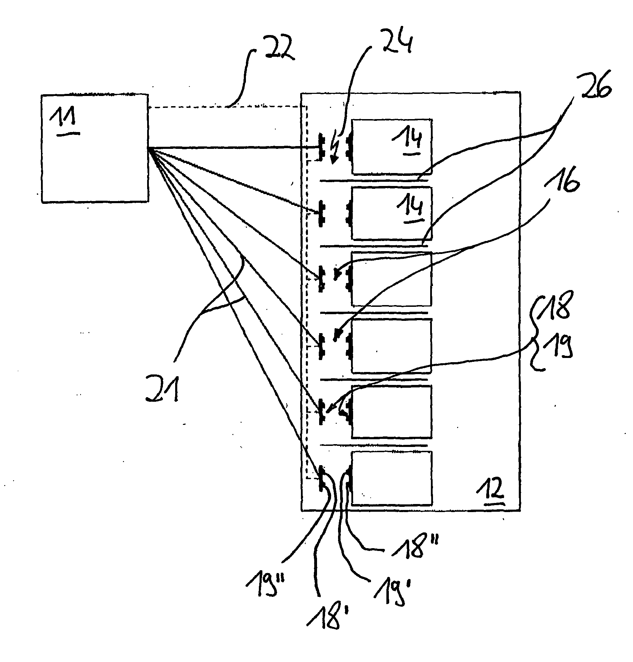

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

Die einzige Figur der Zeichnung zeigt ein schematisches Blockschaltbild eines Ausführungsbeispiels einer erfindungsgemäßen elektrischen Schaltung zur Ansteuerung eines Leistungshalbleiterschaltelements.

Die in der Figur dargestellte elektrische Schaltung kann im Bereich der Leistungselektronik eingesetzt werden, insbesondere unter Verwendung von gesteuerten Leistungshalbleiterschaltelementen. Die Schaltung weist eine Steuereinheit 11 und eine Schalteinheit 12 auf. Bei der Steuereinheit 11 kann es sich um ein Rechengerät handeln, das die Ansteuersignale für die Schalteinheit 12 erzeugt. Bei der Schalteinheit 12 kann es sich allgemein um einen Stromrichter, beispielsweise um einen Umrichter oder einen Wechselrichter oder dergleichen handeln, der unter Verwendung von Leistungshalbleiterschaltelementen zur Umformung eines Stroms vorgesehen ist.

Die Schalteinheit 12 weist eine Mehrzahl von Treibermodulen 14 auf, mit deren Hilfe die von der Steuereinheit 11 vorgegebenen Ansteuersignale aufbereitet und dann an die Leistungshalbleiterschaltelemente weitergegeben werden. Die Leistungshalbleiterschaltelemente sind in der Figur nicht näher dargestellt. Es kann sich dabei um sogenannte IGBTs (IGBT = insulated gate bipolar transistor) oder um sogenannte GTOs (GTO = gate turn off transistor) oder dergleichen handeln. Die Leistungshalbleiterschaltelemente können als Bestandteil der Schalteinheit 12 oder separat davon vorgesehen sein.

Jedem der Treibermodule 14 ist eine optische Übertragungsstrecke 16 zugeordnet. Diese ist dazu geeignet, ein oder mehrere Signale bidirektional zu übertragen. Die Übertragung erfolgt dabei über eine Luftstrecke. Nachfolgend wird eine dieser Übertragungsstrecken beispielhaft beschrieben.

In der Figur ist die Übertragungsstrecke 16 dazu vorgesehen, zwei Signale zu übertragen, und zwar jeweils ein Signal pro Übertragungsrichtung. Zu diesem Zweck sind zwei Sender 18, und zwei Empfänger 19 vorgesehen, die jeweils auf unterschiedlichen Seiten der Übertragungsstrecke 16 angeordnet sind. Vorzugsweise ist auf jeder Seite der Übertragungsstrecke ein sogenannter Transceiver vorhanden, also ein integriertes Bauelement, das einen Sender und einen Empfänger enthält. Der Abstand der Sender 18 und Empfänger 19 innerhalb der Übertragungsstrecke 16, also der Abstand der beiden die Übertragungsstrecke 16 bildenden Transceiver ist gering und kann beispielsweise nur wenige Zentimeter betragen.

Die Sender 18 und Empfänger 19 sind in der gezeigten Figur beispielhaft auf einer gemeinsamen Leiterplatte oder dergleichen aufgebracht, auf der auch die Treibermodule 14 vorhanden sind. Ein Sender 18'' und ein Empfänger 19' einer bestimmten Übertragungsstrecke 16 sind benachbart zu dem zugehörigen Treibermodul 14 angeordnet, während der andere Sender 18' und der andere Empfänger 19'' dieser Übertragungsstrecke 16 beispielsweise am Rand der Leiterplatte angeordnet sind.

Der Sender 18'' und der Empfänger 19', die benachbart zu dem Treibermodul 14 angeordnet sind, sind über jeweils eine in der Figur nicht dargestellte Signalleitung mit dem zugehörigen Treibermodul 14 verbunden. Weiterhin werden dieser Sender 18'' und dieser Empfänger 19' von dem Treibermodul 14 in nicht-dargestellter Weise mit Energie versorgt, beispielsweise über jeweils eine Spannungsversorgungsleitung.

Der zu dieser Übertragungsstrecke 16 zugehörige Sender 18' und der ebenfalls zugehörige Empfänger 19'' sind über jeweils eine Signalleitung 21 mit der Steuereinheit 11 verbunden. Weiterhin werden dieser Sender 18' und dieser Empfänger 19'' von der Steuereinheit 11 mit Energie versorgt, und zwar über eine Spannungsversorgungsleitung 22.

Die Energieversorgung der Steuereinheit 11 und damit des Senders 18' und des Empfängers 19'' ist völlig unabhängig von der Energieversorgung des Treibermoduls 14 und damit des Senders 18'' und des Empfängers 19'. Insbesondere kann die Spannungsversorgung des Senders 18' und des Empfängers 19' mit völlig unterschiedlichen Potentialen erfolgen wie die Spannungsversorgung des Senders 18'' und des Empfängers 19'. Insoweit stellt die Übertragungsstrecke 16 eine potentialfreie Übertragungsstrecke dar.

Grundsätzlich können die Sender 18', 18'' und Empfänger 19', 19'' nach jeglichem beliebigen Protokoll betrieben werden. Dabei kann es sich insbesondere um ein serielles Protokoll handeln. Besonders vorteilhaft ist jedoch das nachfolgend erläuterte und bei dem vorliegenden Ausführungsbeispiel verwendete Protokoll.

Der Sender 18' und der zugehörige Empfänger 19' der Übertragungsstrecke 16 bilden eine Schnittstelle nach dem sogenannten IrDA-Protokoll (IrDA = Infrared Data Association). Dabei handelt es sich um ein Protokoll zur optischen Datenübertragung mittels infrarotem Licht über eher kurze Strecken. Entsprechendes gilt für den Sender 18'' und den Empfänger 19'', also für die Gegenrichtung.

Zur Ansteuerung eines Leistungshalbleiterschaltelements werden von der Steuereinheit 11 digitale Steuersignale erzeugt, die von dem Sender 18' der dem Leistungshalbleiterschaltelement zugehörigen Übertragungsstrecke 16 in ein gepulstes Infrarot-Lichtsignal 24 nach dem IrDA-Protokoll umgewandelt werden. Diese Lichtsignale 24 werden dann zu dem zugehörigen Empfänger 19' durch die Luft übertragen. Dort werden die Lichtsignale 24 auf der Grundlage des IrDA-Protokolls in ein digitales Steuersignal zurückgewandelt, das an das zugehörige Treibermodul 14 weitergegeben wird. Von dem Treibermodul 14 wird dann in Abhängigkeit von den empfangenen Steuersignalen das zugehörige Leistungshalbleiterschaltelement angesteuert.

Ein Rückkoppelsignal von dem Leistungshalbleiterschaltelement oder von der Treibermodul 14 wird auf eine entsprechende Weise über den Sender 18'' und den Empfänger 19'' derselben Übertragungsstrecke 16 an die Steuereinheit 11 übertragen.

Zwischen den einzelnen Übertragungsstrecken 16 und gegebenenfalls auch noch zwischen den einzelnen Treibermodulen 14 sind Abschattungen 26 oder Abschirmungen oder dergleichen angeordnet. Diese sind dazu vorgesehen, dass diejenigen Lichtsignale 24, die über eine bestimmte Übertragungsstrecke 16 übertragen werden, in keinem Fall von einem der Empfänger 19 einer anderen Übertragungsstrecke empfangen werden können.

Alternativ kann anstelle der IrDA-Schnittstelle auch eine Schnittstelle nach dem sogenannten Bluetooth-Protokoll zur Anwendung kommen. Dabei handelt es sich um ein Protokoll zur Datenübertragung per Funk über kurze Strecken.

Ganz allgemein handelt es sich bei den Übertragungsstrecken 16 um Schnittstellen, bei denen keine direkte körperliche Verbindung zwischen den Sendern und den jeweils zugehörigen Empfängern vorhanden ist. Die Sender und die Empfänger können hierzu auf unterschiedlichen Leiterplatten oder dergleichen aufgebracht sein.

Sind die Sender und die Empfänger der Übertragungsstrecken 16 auf derselben Leiterplatte aufgebracht, so ist dies derart ausgeführt, dass sich einander zugehörige Sender und Empfänger in keiner Weise berühren oder eine sonstige körperliche Verbindung haben. Wie erläutert wurde, erfolgt die Datenübertragung durch Lichtsignale oder per Funk über eine eher kurze Strecke und vorzugsweise durch die Luft, also ohne dass hierzu eine körperliche Verbindung zwischen dem jeweiligen Sender und dem zugehörigen Empfänger notwendig ist.

Ergänzend können die Sender und die Empfänger mit Hilfe von elektrisch isolierenden Materialien auf der gemeinsamen Leiterplatte aufgebracht sein, so dass auch insoweit keine Verbindung, insbesondere auch keine elektrische Verbindung über Kriechstrecken oder dergleichen, zwischen einem der Sender und dem zugehörigen Empfänger entstehen kann.

## Patentansprüche

1. Elektrische Schaltung zur Ansteuerung eines Leistungshalbleiterschaltelements mit einer Steuereinheit (11) zur Erzeugung eines Steuersignals, mit einem Treibermodul (14) zur Ansteuerung des Leistungshalbleiterschaltelements in Abhängigkeit von dem Steuersignal, und mit einer Einrichtung zur potentialfreien Übertragung des Steuersignals von der Steuereinheit (11) zu dem Treibermodul (14), **dadurch gekennzeichnet, dass** die Einrichtung zur potentialfreien Übertragung einen Sender (18) und einen Empfänger (19) aufweist, zwischen denen keine direkte körperliche Verbindung vorhanden ist.

2. Elektrische Schaltung nach Anspruch 1, wobei der Sender (18) und der Empfänger (19) auf einer gemeinsamen Leiterplatte oder dergleichen aufgebracht sind, ohne sich körperlich zu berühren.

3. Elektrische Schaltung nach Anspruch 2, wobei der Sender (18) und der Empfänger (19) mit Hilfe isolierender Materialien auf der Leiterplatte montiert sind.

4. Elektrische Schaltung nach einem der Ansprüche 1 bis 3, wobei die Übertragung der Steuersignale über eine eher kurze Strecke und vorzugsweise durch die Luft erfolgt.

5. Elektrische Schaltung nach einem der Ansprüche 1 bis 4, wobei die Übertragung der Steuersignale durch Lichtsignale oder per Funk erfolgt.

6. Elektrische Schaltung nach Anspruch 5, wobei die Übertragung der Lichtsignale nach einem seriellen Protokoll, insbesondere nach dem IrDA-Protokoll erfolgt.

7. Elektrische Schaltung nach einem der Ansprüche 1 bis 6, wobei Mittel vorgesehen sind, mit denen ein Rückkoppelsignal auf dieselbe Weise von dem Treibermodul (14) zu der Steuereinheit (11) übertragbar ist.

8. Elektrische Schaltung nach einem der Ansprüche 1 bis 7, **gekennzeichnet durch** deren Verwendung im Bereich der Leistungselektronik, insbesondere bei einem Stromrichter.
